# EUROPÄISCHE PATENTANMELDUNG

(11) **EP 3 285 304 A1**
(43) Veröffentlichungstag der Anmeldung: **21.02.2018**
(21) Anmeldenummer: 16184713.2
(22) Anmeldetag: 18.08.2016
(51) Int. Cl.: H01L 31/048, B32B 17/00, H01L 31/049, H02S 20/26

(54) **VERBUNDGLAS-BAUELEMENT MIT SOLARZELLEN FÜR FAHRZEUGDÄCHER UND GEBÄUDE**

(71) Anmelder: A2 - Solar Advanced and Automotive Solar Systems GmbH, 99099 Erfurt (DE)
(72) Erfinder: Wecker, Reinhard, 99425 Weimar (DE)
(74) Vertreter: Jöstingmeier, Martin

(57) **Zusammenfassung**

Es wird ein Bauelement für die Fassade eines Bauwerks oder für den Deckel eines Fahrzeugs, sowie ein Verfahren zur Herstellung eines solchen Bauelements offenbart. Das Bauelement umfasst eine äußere Glasscheibe (10) mit wenigstens einer Splitterschutzfolie (16) und wenigstens einer Solarzelle (20) zwischen der Glasscheibe und der Splitterschutzfolie, wobei am Rand der Glasscheibe wenigstens ein fest mit der Folie verbundener Folienträger (17) angeordnet ist, und wobei die Glasscheibe und der Folienträger zur Verklebung mit einem Bauwerk oder einem Fahrzeug vorgesehen ist. Wenigstens ein Zellverbinder (41), welcher zur elektrischen Kontaktierung mit der wenigstens einen Solarzelle verbunden ist, wird zumindest abschnittsweise an der Unterseite des Folienträgers entlang geführt, so dass der wenigstens eine Zellverbinder von einem Klebemittel (65) zur Verbindung mit dem Bauwerk oder dem Fahrzeug zumindest teilweise fest umschlossen ist und mit diesem Klebemittel einen Kraftschluss und/oder Formschluss bildet. Dadurch lässt sich eine hohe mechanische Festigkeit der Anordnung sowie eine größere für Solarzellen nutzbare Fläche erreichen.

## Beschreibung

### Technisches Gebiet

Die Erfindung betrifft ein Bauelement mit Solarzellen, welches als Glasdeckel für Fahrzeugdächer oder auch als Fassadenelement für Gebäude einsetzbar ist.

### Stand der Technik

Sowohl beim Einsatz an Gebäuden als auch in Kraftfahrzeugen werden hohe Anforderungen an die mechanische Festigkeit und Stabilität solcher Bauelemente gestellt. So müssen diese Bauelemente beim Einsatz in Fassaden insbesondere durch Windbelastungen hohen Zug- und Druckkräften standhalten. Zudem dürfen auch bei einer Beschädigung des Bauelements nicht einzelne Bestandteile von der Fassade herabfallen. Beim Einsatz als Glasdeckel in Kraftfahrzeugen muss ein solches Bauelement ebenfalls hohen Zug- und Druckkräften widerstehen. Insbesondere können bei Unfällen kurzfristige, extrem starke Belastungen auftreten. Auch in solchen Situationen dürfen sich nicht einzelne Bestandteile von dem Bauelement lösen. Es soll hier das ganze Bauelement fest am Fahrzeug gehalten werden.

In der DE 10 2004 059959 A1 ist ein Bauelement zur Verglasung eines Bauwerks offenbart. Es weist eine Glasplatte auf, an deren Unterseite Solarzellen angebracht sind. Weiterhin ist auf der Rückseite der Solarzellen eine Splitterschutzfolie vorgesehen. Eine solche Splitterschutzfolie ist üblicherweise fest durch Laminieren mit den Solarzellen und mit der Glasplatte verbunden. Sie kann somit das Herausfallen von einzelnen Splittern aus der Glasplatte verhindern. Weiterhin offenbart dieses Dokument eine mechanische Befestigung der Splitterschutzfolie, um die mechanische Stabilität weiter zu erhöhen. Nachteilig an dieser Anordnung ist der höhere Fertigungsaufwand durch die separate Befestigung der Splitterschutzfolie, sowie eine begrenzte Wirksamkeit der Maßnahme durch die begrenzte Reißfestigkeit der Splitterschutzfolie.

In der EP 1 006 593 B1 ist ein Solarmodul mit einem integrierten Steckverbinder offenbart. Dieser ermöglicht eine besonders einfache elektrische Verbindung mit dem Solarmodul.

### Darstellung der Erfindung

Der Erfindung liegt die Aufgabe zugrunde, ein Bauelement mit Solarzellen zur Verglasung eines Bauwerks und/oder zum Einsatz als Deckel für ein Kraftfahrzeug sowie ein Verfahren zur Herstellung eines solchen Bauelements derart auszugestalten, dass dieses eine erhöhte mechanische Stabilität und Festigkeit aufweist. Weiterhin soll die mit Solarzellen bestückbare Fläche vergrößert werden. Zudem soll es mit relativ geringem Aufwand zu geringen Kosten herstellbar sein.

Diese Aufgabe wird durch eine Vorrichtung nach Anspruch 1 gelöst. Vorteilhafte Ausgestaltungen der Erfindung sind in den Unteransprüchen angegeben.

Ein erfindungsgemäßes Bauelement umfasst eine Glasscheibe mit wenigstens einer Solarzelle. Die Glasscheibe besteht bevorzugt aus Einscheiben-Sicherheitsglas (ESG), welches bevorzugt durch eine spezielle Wärmebehandlung eine erhöhte Stoß- und Schlagfestigkeit aufweist. Die Glasscheibe kann von ihrer Größe und Form an das jeweilige Einsatzgebiet, wie beispielsweise für eine Gebäudefassade oder für ein Kraftfahrzeug, ausgelegt sein. Sie kann auch eine Einfärbung oder eine Bedruckung aufweisen. Die Glasscheibe ist zu einer Verklebung mit einer Karosserie eines Fahrzeugs oder einem Halterahmen beispielsweise einer Fassade vorgesehen.

Auf der Glasscheibe befindet sich wenigstens eine Solarzelle. Diese wenigstens eine Solarzelle ist bevorzugt auf der Unterseite bzw. Innenseite der Glasscheibe angeordnet, so dass sie durch die Glasscheibe von Umwelteinflüssen geschützt ist. Bevorzugt ist eine größere Anzahl von Solarzellen, besonders bevorzugt in einer matrixförmigen Anordnung vorgesehen, um eine wirtschaftliche Herstellung zu ermöglichen. Um eine höhere und damit leichter zu verarbeitende Ausgangsspannung zu erreichen, werden die Solarzellen bevorzugt hintereinander (in Serie) geschaltet. Grundsätzlich ist aber auch eine Parallelschaltung oder eine kombinierte Serien-/Parallelschaltung möglich. Zur Verbindung der Solarzellen untereinander sind Zellverbinder vorgesehen. Durch derartige Zellverbinder werden bevorzugt benachbarte Solarzellen miteinander verbunden. Zudem dienen diese Zellverbinder auch zum äußeren Anschluss der Solarzellen, um sie beispielsweise mit einer Last oder einem Verbraucher zu verbinden. Die wenigstens eine Solarzelle ist bevorzugt fest mit der Glasscheibe verbunden. Eine solche Verbindung kann durch Aufkleben, Laminieren oder ein anderes, dem Stand der Technik entsprechendes Befestigungsverfahren erfolgen. Besonders bevorzugt wird die wenigstens eine Solarzelle mit Hilfe wenigstens einer Folie auf die Glasscheibe laminiert. Es kann hierbei wenigstens eine Folie zwischen der wenigstens einen Solarzelle und der Glasscheibe vorgesehen sein. Besonders bevorzugt ist es, wenn wenigstens eine Folie auf der der Glasscheibe abgewandten Seite der wenigstens einen Solarzelle vorgesehen ist, so dass die wenigstens eine Solarzelle zwischen der Folie und der Glasscheibe eingeschlossen ist. Besonders bevorzugt ist es, wenn eine solche Folie eine Ethyl-Vinyl-Acetat-Folie (EVA) oder eine Polyvinyl-Butyral-Folie (PVB) ist. Derartige Folien zeichnen sich durch hohe mechanische Stabilität und hohe Reißfestigkeit aus. Durch den Einsatz einer solchen Folie kann eine hohe Splitterfestigkeit des Bauelements erreicht werden.

Bei einem Bruch der Glasscheibe entsteht eine sehr hohe Zugspannung mit der Folge einer hohen Streckung auf die Folie. Dies kann dazu führen, dass sich die Folie von der Karosserie bzw. dem Halterahmen löst. Dadurch verliert die Folie ihre Schutzwirkung. Um eine wesentlich bessere Fixierung der Folie an der Karosserie bzw. dem Halterahmen zu erzielen, wird an der Außenseite der Scheibe ein fest mit der Folie verbundener Folienträger eingesetzt. Der Folienträger kann auf zwei gegenüberliegenden Seiten, auf 4 Seiten oder bevorzugt auch umlaufend angeordnet sein. Er hat vorzugsweise eine höhere Steifigkeit und/oder eine geringere Elastizität als die Folie. Der Folienträger umfasst bevorzugt ein mechanisch steifes Material wie beispielsweise einen Glasfaser- oder Kohlefaser-Verbundwerkstoff. Besonders bevorzugt hat er eine raue Oberfläche, welche eine gute Verklebung oder Laminierung mit der Folie ermöglicht. Bevorzugt wird die Folie zwischen dem Folienträger und der Scheibe eingeklemmt. Dadurch kann die Folie nur mit einem deutlich größeren Kraftaufwand zwischen Folienträger und Scheibe herausgezogen werden.

Weiterhin ist es bevorzugt, wenn wenigstens ein Zellverbinder durch wenigstens eine Bohrung im Folienträger geführt ist. Damit ergibt sich eine weitere Verbesserung der mechanischen Belastbarkeit.

Eine weitere vorteilhafte Ausgestaltung umfasst eine Glasscheibe mit wenigstens einer Solarzelle, wie zuvor beschrieben. Weiterhin ist ein flächiger innerer Träger vorgesehen, so dass die wenigstens eine Solarzelle zwischen der Glasscheibe und dem inneren Träger eingeschlossen ist. Der innere Träger kann wie der zuvor beschriebene Folienträger ausgestaltet sein. Er umfasst bevorzugt ein mechanisch steifes Material wie beispielsweise einen Glasfaser- oder Kohlefaser- Verbundwerkstoff. Auch hier kann wenigstens ein Zellverbinder durch wenigstens eine Bohrung des inneren Trägers hindurchgeführt sein.

Ein weiteres erfindungsgemäßes Bauelement umfasst zwei Glasscheiben mit wenigstens einer Solarzelle zwischen den Glasscheiben, wobei die Glasscheiben in zumindest einem Bereich am Rand mit einem Rahmen verbunden sind. Die Glasscheiben und der Rahmen bilden ein eigenständiges Bauelement, welches in die Karosserie eines Fahrzeugs oder einen Halterahmen beispielsweise einer Fassade eingesetzt werden kann. Weiterhin ist wenigstens ein Zellverbinder zur elektrischen Verbindung der wenigstens einen Solarzelle vorgesehen, welcher zumindest teilweise in den Rahmen hineinragt und bevorzugt Mittel zur Vergrößerung der Haftung in dem Rahmen aufweist. Bevorzugt ist der wenigstens eine Zellverbinder zumindest teilweise von dem Rahmen fest umschlossen, so dass diese einen Kraftschluss und/oder Formschluss bilden. Der wenigstens eine Zellverbinder kann auch durch den Rahmen hindurchgehen, so dass er mach dem durchtritt des Rahmens elektrisch kontaktierbar ist.

Bevorzugt umschließt der Rahmen beide Glasscheiben am Rand. Der Rahmen umfasst bevorzugt ein steifes oder teilelastisches Material, besonders bevorzugt einen Schaum. Ein bevorzugtes Material für den Rahmen ist Polyurethan (PU). Der Rahmen hat bevorzugt eine minimale Elastizität und erlaubt eine gewisse mechanische Ausdehnung der Glasscheibe gegenüber der Karosserie eines Fahrzeugs oder einen Halterahmen beispielsweise einer Fassade und absorbiert Schwingungen und Stöße. Zudem ermöglicht er selbst oder mit zusätzlichen Dichtmitteln eine Abdichtung, so dass insbesondere von außen kein Wasser eindringen kann.

Es ist weiterhin vorteilhaft, wenn in dem Rahmen zusätzliche Versteifungs- bzw. Halteelemente vorgesehen sind. Dies können beispielsweise Einleger aus Stahl sein. So können bevorzugt Befestigungsschrauben oder Bolzen zur Befestigung des Rahmens mit der Karosserie eines Fahrzeugs oder dem Halterahmen beispielsweise einer Fassade vorgesehen sein. Weiterhin können zusätzliche Abdichtungselemente zur Abdichtung des Rahmens gegenüber der Karosserie eines Fahrzeugs oder dem Halterahmen beispielsweise einer Fassade vorgesehen sein.

Durch die hier beschriebene Ausführungsform eines Bauelements mit Solarzellen kann eine äußerst kompakte und auch optisch ansprechende Ausgestaltung realisiert werden. Es ergibt sich eine hohe mechanische Stabilität, ohne dass eine die äußere Glasscheibe auf der Außenseite umgreifende Befestigung benötigt wird. Zudem ist es möglich, die Solarzellen bis nahe an den Rand der äußeren Glasscheibe bzw. der inneren Glasscheibe anzuordnen, da die für die Halterung der Glasscheiben notwendigen mechanischen Komponenten außerhalb der Glasscheibe bzw. unterhalb der Glasscheibe angeordnet sind. Somit ergibt sich eine höhere Fläche an Solarzellen und somit eine höhere Energieausbeute als mit dem bekannten Stand der Technik.

In einer weiteren vorteilhaften Ausgestaltung der Erfindung umfasst das Bauelement zwei Glasscheiben mit wenigstens einer Solarzelle zwischen den Glasscheiben. Weiterhin ist wenigstens eine der Glasscheiben zu einer Verklebung mit einer Karosserie eines Fahrzeugs oder einem Halterahmen beispielsweise einer Fassade vorgesehen. Eine äußere Glasscheibe ist zur Fahrzeug- bzw. Fassadenaußenseite ausgerichtet, während eine innere Glasscheibe zur Innenseite ausgerichtet ist. Besonders vorteilhaft ist es, wenn die innere Glasscheibe zur Verklebung mit der Karosserie eines Fahrzeugs oder dem Halterahmen beispielsweise einer Fassade vorgesehen ist. Die äußere Glasscheibe kann zur Abdichtung mit einer Dichtung, beispielsweise einem Dichtprofil gegenüber der Karosserie eines Fahrzeugs oder dem Halterahmen beispielsweise einer Fassade vorgesehen sein. Weiterhin ist bevorzugt wenigstens ein Zellverbinder zur elektrischen Verbindung der wenigstens einen Solarzelle um den Rand der inneren Glasscheibe geführt. Der wenigstens eine Zellverbinder ist bevorzugt zumindest abschnittsweise an der Unterseite der inneren Glasscheibe entlang geführt. Somit kann er bei einer Verklebung mit einer Karosserie oder einem Halterahmen durch die Verklebung zusätzlich fixiert werden. Für die Verklebung geeignete Klebstoffe sind beispielsweise Polyurethane oder Silikone.

Durch diese Ausführungsform eines Bauelements mit Solarzellen kann eine noch kompaktere und auch optisch ansprechende Ausgestaltung realisiert werden. Es ergibt sich eine hohe mechanische Stabilität, ohne dass eine die äußere Glasscheibe auf der Außenseite umgreifende Befestigung benötigt wird. Zudem ist es möglich, die Solarzellen bis nahe an den Rand der äußeren Glasscheibe bzw. der inneren Glasscheibe anzuordnen, da der Verbund aus äußerer Glasscheibe und innerer Glasscheibe durch die innere Glasscheibe mit einer Karosserie oder im alte Rahmen verbunden wird. Somit ergibt sich eine höhere Fläche an Solarzellen und somit eine höhere Energieausbeute als mit dem bekannten Stand der Technik.

Nachfolgend sind noch einige besondere Ausgestaltungen beschrieben, die sich auf alle hierin dargestellten Ausführungsformen beziehen, sofern nicht ausdrücklich anders erwähnt. In allen hier offenbarten Ausführungsformen sind die Glasscheiben bevorzugt durch ein Kunststoffmaterial, besonders bevorzugt in Form einer Folie miteinander verbunden. Besonders bevorzugt ist es, wenn eine solche Folie eine Ethyl-Vinyl-Acetat-Folie (EVA) oder eine Polyvinyl-Butyral-Folie (PVB) ist. Derartige Folien zeichnen sich durch hohe mechanische Stabilität und hohe Reißfestigkeit aus. Durch den Einsatz einer solchen Folie kann eine hohe Splitterfestigkeit des Bauelements erreicht werden. Besonders bevorzugt es sind die beiden Glasscheiben zusammen mit dem Kunststoffmaterial und der wenigstens einen Solarzelle zu einer Verbundglasscheibe verbunden. Die Herstellung der Verbindung kann bevorzugt durch Laminieren erfolgen.

Vorteilhafterweise weist mindestens eine der Glasscheiben eine erhöhte Stoß- und Schlagfestigkeit auf, welche beispielsweise durch eine spezielle Wärmebehandlung erreicht werden kann. Die Glasscheiben können von ihrer Größe und Form an das jeweilige Einsatzgebiet, wie beispielsweise für eine Gebäudefassade oder für ein Kraftfahrzeug, ausgelegt sein. Sie können auch eine Einfärbung oder eine Bedruckung aufweisen.

Zwischen den Glasscheiben befindet sich wenigstens eine Solarzelle. Diese wenigstens eine Solarzelle ist bevorzugt vollständig durch ein Kunststoffmaterial eingebettet, so dass sie zusammen mit den Glasscheiben vor Umwelteinflüssen geschützt ist. Bevorzugt ist eine größere Anzahl von Solarzellen, besonders bevorzugt in einer matrixförmigen Anordnung vorgesehen, um eine wirtschaftliche Herstellung zu ermöglichen. Um eine höhere und damit leichter zu verarbeitende Ausgangsspannung zu erreichen, werden die Solarzellen bevorzugt hintereinander (in Serie) geschaltet. Grundsätzlich ist aber auch eine Parallelschaltung oder eine kombinierte Serien-/Parallelschaltung möglich. Zur Verbindung der Solarzellen untereinander sind Zellverbinder vorgesehen. Durch derartige Zellverbinder werden bevorzugt benachbarte Solarzellen miteinander verbunden. Zudem dienen diese Zellverbinder auch zum äußeren Anschluss der Solarzellen, um sie beispielsweise mit einer Last oder einem Verbraucher zu verbinden.

Um im Falle der Beschädigung eines Bauelements, wie es beispielsweise in einer Fassade eingebaut ist, oder auch im Falle eines Unfalls oder des Bruchs eines Glasdeckels eines Kraftfahrzeugs, ein Herausbrechen von Teilen aus dem Bauelement oder des ganzen Bauelements selbst aus einer Halterung zu vermeiden, wird eine stabile Verankerung der Glasscheiben erreicht, indem wenigstens ein Zellverbinder der Solarzellen in den Rahmen eingebettet ist bzw. zusammen mit der inneren Glasscheibe mit der Karosserie eines Fahrzeugs oder dem Halterahmen beispielsweise einer Fassade verklebt ist. Bevorzugt weisen die Zellverbinder zusätzliche Mittel zur Erhöhung der mechanischen Stabilität und der Auszugskraft aus dem Rahmen auf. Derartige Mittel können beispielsweise Verformungen oder Prägungen der Zellverbinder und/oder auch Querverbinder zur Verbindung mehrerer Zellverbinder sein. Da die Zellverbinder nun fest in dem Rahmen oder mit der Karosserie eines Fahrzeugs oder dem Halterahmen beispielsweise einer Fassade verankert sind und weiterhin die einzelnen Solarzellen über die Zellverbinder fest miteinander verbunden sind, ergibt sich eine besonders stabile Struktur. Diese wird zusätzlich durch eine vorzugsweise vorgesehene Folie weiter stabilisiert. Da keine zusätzlichen Halte-und Befestigungsmittel notwendig sind, um eine hohe mechanische Stabilität zu erreichen, ergibt sich ein einfacheres und kostengünstigeres Bauelement, welches gleichzeitig eine deutliche höhere Stabilität erreicht.

In einer besonders vorteilhaften Ausgestaltung der Erfindung wird eine höhere Stabilität dadurch erreicht, dass wenigstens zwei Zellverbinder mit wenigstens einem Querverbinder elektrisch und/oder mechanisch verbunden sind und der wenigstens eine Querverbinder wenigstens teilweise, bevorzugt vollständig in dem Rahmen oder in die Verklebung mit der Karosserie eines Fahrzeugs oder dem Halterahmen beispielsweise einer Fassade eingeschlossen ist. Zusätzlich bzw. alternativ kann noch wenigstens ein weiterer Querverbinder zur Verbesserung der elektrischen Verbindung zwischen den Solarzellen vorgesehen sein, welcher nicht in dem Rahmen oder in die Verklebung mit der Karosserie eines Fahrzeugs oder dem Halterahmen beispielsweise einer Fassade eingeschlossen ist.

In einer weiteren vorteilhaften Ausgestaltung der Erfindung weist der wenigstens eine Zellverbinder und/oder Querverbinder Mittel zur Erhöhung der Stabilität der Befestigung bzw. zur Erhöhung der Auszugskraft aus dem Rahmen oder der Verklebung mit der Karosserie eines Fahrzeugs oder dem Halterahmen beispielsweise einer Fassade auf. Solche Mittel können beispielsweise eine Verformung des wenigstens einen Zellverbinders sein. So kann dieser wellenförmig oder mäanderförmig verformt sein. Alternativ bzw. zusätzlich kann der wenigstens eine Zellverbinder auch eine Struktur der Oberfläche aufweisen. So kann die Oberfläche beispielsweise besonders rau sein. Es können aber auch Öffnungen oder Bohrungen in dem wenigstens einem Zellverbinder vorhanden sein, welche ein Eindringen oder bevorzugt ein Durchdringen des Rahmens ermöglichen. Grundsätzlich kann auch ein Querverbinder diese Mittel zur Verbesserung der Auszugskraft aufweisen.

Alle hier vorgestellten Ausführungsformen sind grundsätzlich auch ohne Solarzellen und damit ohne Zellverbinder realisierbar. Allerdings ist die erzielbare Stabilität deutlich geringer.

Ein erfindungsgemäßes Verfahren betrifft die Herstellung eines Bauelements für die Fassade eines Bauwerks oder für den Deckel eines Fahrzeugs. Dieses Verfahren umfasst die Schritte Bereitstellen einer ersten Glasscheibe sowie die Anordnung wenigstens einer Solarzelle an dieser ersten Glasscheibe, die Anordnung einer zweiten Glasscheibe über der wenigstens einen Solarzelle und schließlich das Verkleben bzw. Laminieren der beiden Glasscheiben zu einer Verbundglasscheibe. Weiterhin wird wenigstens ein Teil wenigstens eines Zellverbinders in einen Rahmen eingebettet. Bevorzugt wird zwischen der ersten Glasscheibe und der wenigstens einen Solarzelle und/oder zwischen der zweiten Glasscheibe und der wenigstens einen Solarzelle wenigstens ein Kunststoffmaterial eingebracht. Alternativ kann auch wenigstens ein Teil eines Zellverbinders in einem Rahmen oder in eine Verklebung mit der Karosserie eines Fahrzeugs oder dem Halterahmen beispielsweise einer Fassade eingebettet sein. In weiteren Ausgestaltungen des Verfahrens sind die Schritte zur Herstellung der entsprechenden Ausführungsformen wie oben beschrieben inbegriffen.

### Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben.
Figur 1 zeigt ein erfindungsgemäßes Bauelement in einer Draufsicht.
Figur 2 zeigt ein bevorzugtes Ausführungsbeispiel mit Folienträger im Schnitt.
Figur 3 zeigt eine Variante der Figur 2
Figur 4 zeigt ein weiteres Ausführungsbeispiel mit innerem Träger im Schnitt.
Figur 5 zeigt eine Variante der Figur 4
Figur 6 zeigt ein Ausführungsbeispiel einer Verbundglasscheibe im Schnitt.
Figur 7 zeigt ein Ausführungsbeispiel einer weiteren Verbundglasscheibe im Schnitt.

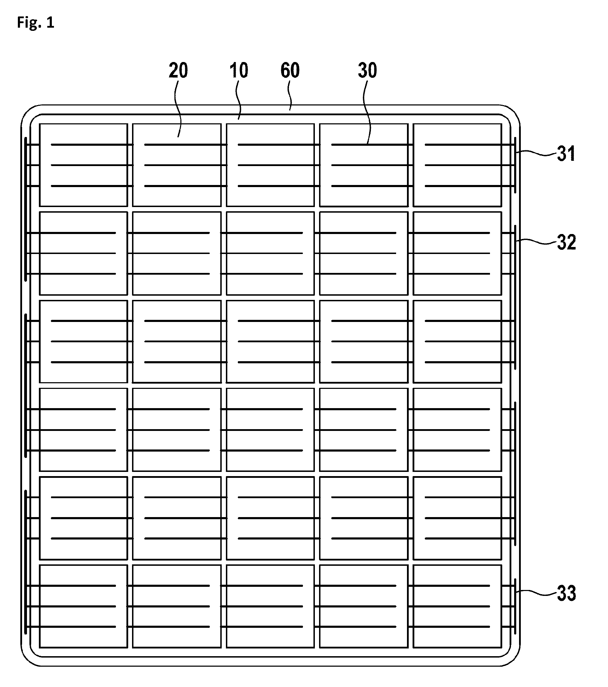

In Figur 1 ist ein erfindungsgemäßes Bauelement schematisch in der Draufsicht dargestellt. Das Bauelement umfasst eine obere Glasscheibe 10. Die Glasscheibe kann jede beliebige, der Aufgabe angepasste Form aufweisen. So kann sie beispielsweise abgerundete Ecken haben, wie in der Figur dargestellt. Ebenso kann sie in einer oder zwei Achsen gewölbt sein, oder eine andere freie, gekrümmte Form aufweisen, um sie beispielsweise an die Kontur eines Fahrzeugdachs anzupassen. Anstelle einer rechteckigen Form kann sie auch beliebige andere Formen haben. Bevorzugt hinter bzw. unter der oberen Glasscheibe und somit vor äußeren Umwelteinflüssen geschützt, ist wenigstens eine Solarzelle 20 angeordnet. In diesem Ausführungsbeispiel sind 30 Solarzellen in 6 Reihen mit jeweils 5 Solarzellen unter der Glasscheibe angeordnet. Grundsätzlich kann jede andere Anzahl von Solarzellen verwendet werden. Es müssen auch nicht quadratische Solarzellen, wie hier dargestellt verwendet werden. Die Solarzellen können grundsätzlich jede beliebige Form, auch rund, haben. Die elektrische Kontaktierung der Solarzellen 20 erfolgt durch Zellverbinder 30.

In dem hier dargestellten Beispiel sind die Solarzellen hintereinander geschaltet, so dass ein Zellverbinder von einer Solarzelle eine benachbarte Solarzelle kontaktiert. Die einzelnen Reihen von Solarzellen sind durch Querverbinder 31, 32 und 33 kontaktiert. Die Querverbinder 32 sind zur Verbindung von Reihen untereinander vorgesehen, während die Querverbinder 31 und 33 zur Kontaktierung der ersten bzw. letzten Solarzelle der Anordnung dienen. Es kann hier an die Querverbinder 31 und 33 ein Stromverbraucher bzw. eine Last angeschlossen werden, welche durch den Strom aus den Solarzellen gespeist wird.

Weiterhin ist noch der Rahmen 60 dargestellt, der die Glasscheiben umschließt. Hier ist ein umlaufender Rahmen dargestellt. Es ist aber offensichtlich, dass dieser auch nur bestimmt Abschnitte umfassen kann. So könnte beispielsweise ein Rahmen aus Segmenten mit Lücken zwischen den einzelnen Segmenten bestehen.

Bevorzugt ragt wenigstens ein äußerer Zellverbinder 30 der Solarzellen 20 an deren Enden in den Rahmen 60 hinein. Weiterhin sind bevorzugt die Querverbinder 31, 32 und 33 in dem Rahmen bzw. in die Verklebung eingeschlossen. Dadurch, dass die Zellverbinder benachbarte Solarzellen einer jeden Zeile miteinander verbinden, ergibt sich eine kettenartige Struktur von miteinander verbundenen Solarzellen, welche wiederum über die äußeren Zellverbinder in dem Rahmen befestigt ist. Versuche haben ergeben, dass diese Struktur eine sehr hohe mechanische Stabilität aufweist und damit zur Gesamtstabilität des Bauelements wesentlich beiträgt. So kann hierdurch die notwendige Kraft zum Herausreißen des Bauelements aus einer äußeren Halterung wesentlich erhöht werden, was die Robustheit und Zuverlässigkeit bei Fassadenelementen und die Unfallsicherheit bei Deckeln für Kraftfahrzeuge deutlich erhöht.

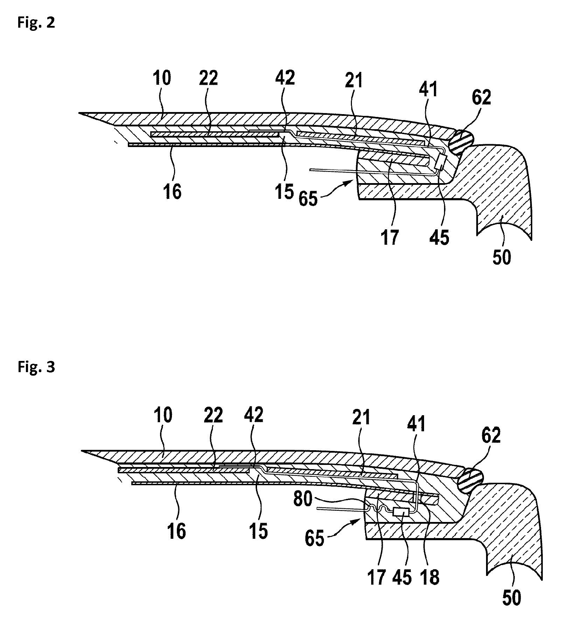

Figur 2 zeigt eine bevorzugte Ausführungsform im Schnitt. Eine Glasscheibe 10 und Splitterschutzfolie 16 schließen wenigstens eine Solarzelle 21, 22 ein. Zur Verstärkung der Splitterschutzfolie ist am Rand ein Folienträger 17 angeordnet. Er ist bevorzugt fest mit der Folie verbunden. Bevorzugt ist ein Folienträger jeweils an 2 oder 4 gegenüberliegenden Seiter der Folie angeordnet. Besonders bevorzugt ist der Folienträger umlaufend um die Folie angeordnet. Der Folienträger umfasst bevorzugt ein mechanisch steifes Material wie einen Glasfaseroder Kohlefaser-Verbundwerkstoff. Die wenigstens eine Solarzelle ist bevorzugt in ein Kunststoffmaterial, besonders bevorzugt EVA eingebettet. Dieses Material verbindet bevorzugt die äußere Glasscheibe 10 und die Splitterschutzfolie. Alternativ kann auch die Splitterschutzfolie unmittelbar mit den Solarzellen zusammenlaminiert sein. Das Bauelement wird nun ähnlich wie eine Windschutzscheibe in die Karosserie bzw. den Rahmen eines Fahrzeugs durch ein Klebemittel 65 eingeklebt. Die Zellverbinder 41 einer am Rand liegenden Solarzelle 21 werden zwischen der Glasscheibe und dem Folienträger bzw. der Folie hin-aus und durch das für Klebemittel 65 hindurch geführt. Es gibt sich hierdurch eine sehr stabile Befestigung des Bauelements an dem Fahrzeug. Dadurch, dass die Zellverbinder durch das Klebemittel hindurch geführt werden ergibt sich zu-dem eine wesentliche Erhöhung der mechanischen Stabilität, da die Zellverbinder selbst hier nun auch im Falle einer extrem starken Belastung, wie diese beispielsweise bei einem Unfall auftreten kann, auf Zug belastet werden können und somit zur weiteren Stabilisierung des Bauelements beitragen. Um eine weitere Erhöhung der mechanischen Festigkeit zu erreichen kann auch wenigstens ein Querverbinder 45 in die Einbettung 15 und/oder das Klebemittel 65 mit eingebettet sein. Bevorzugt besteht hier ein Form- oder Kraftschluss. Bevorzugt ist noch eine äußere Dichtung 62 zur Abdichtung der äußeren Glasscheibe gegen-über dem Fahrzeug vorgesehen.

In diesem Ausführungsbeispiel ist die Solarzelle 21 mit der Solarzelle 22 über den Zellverbinder 42 verbunden. Die Solarzelle 21 kann über den Zellverbinder 41 nach außen kontaktiert oder mit einer Solarzelle einer anderen Reihe durch einen Querverbinder 45 verbunden werden. Ein Querverbinder 45 kann auch zur externen Kontaktierung eingesetzt werden. Um eine besonders hohe mechanische Festigkeit zu erreichen, kann der Querverbinder 45 vollständig oder teilweise von dem Rahmen (60) fest umschlossen sein. Bevorzugt besteht hier ein Form- oder Kraftschluss. Somit können über den Querverbinder 45 durch den Zellverbinder Zugkräfte von den Solarzellen aufgenommen werden, was zu einer wesentlichen Verbesserung der Stabilität dient.

Figur 3 zeigt eine weitere Variante, bei der der Zellverbinder 41 zur Verbesserung der Stabilität durch wenigstens eine Bohrung 18 in dem Folienträger 17 geführt ist. weiterhin kann ein verformter, strukturierter Bereich 80 vorgesehen sein, um die Haftung des Zellverbinders in dem Klebemittel 65 zu erhöhen.

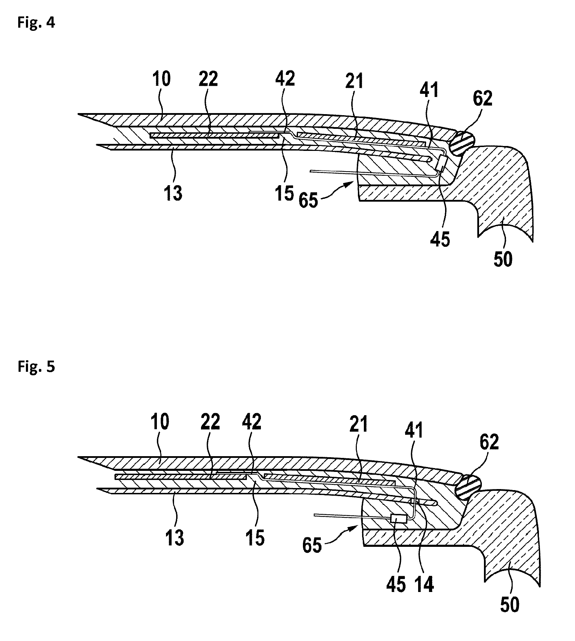

Figur 4 zeigt eine weitere Ausführungsform im Schnitt. Hier ist anstelle der Splitterschutzfolie ein innerer Träger vorgesehen. Er umfasst bevorzugt ein mechanisch steifes Material wie einen Glasfaser- oder Kohlefaser-Verbundwerkstoff. Da er unmittelbar zu Stabilisierung der Scheibe beiträgt, kann der Folienträger 17 entfallen. Alternativ könnte durch einen Folienträger wie oben beschrieben, die Festigkeit weiter erhöht werden.

Figur 5 zeigt eine weitere Variante, bei der der Zellverbinder 41 zur Verbesserung der Stabilität durch wenigstens eine Bohrung 18 in dem Folienträger 17 geführt ist.

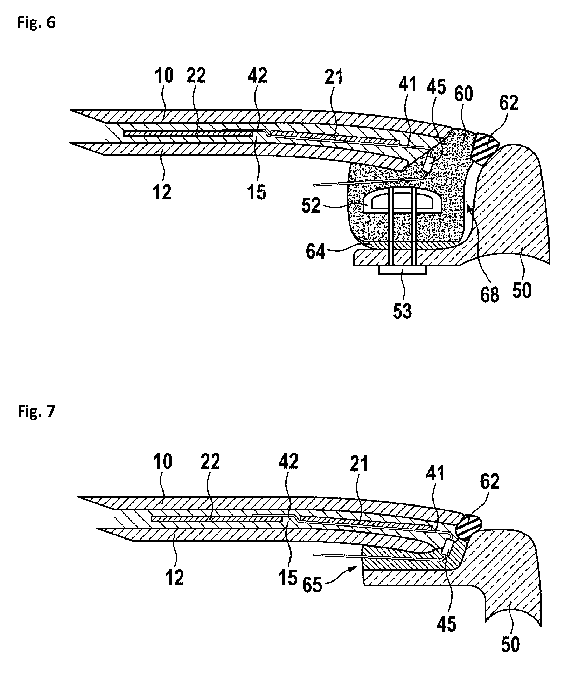

Figur 6 zeigt ein Bauelement einer weiteren Ausführungsform im Schnitt. Eine äußere Glasscheibe 10 und eine innere Glasscheibe 12 schließen wenigstens eine Solarzelle 21, 22 ein. Die wenigstens eine Solarzelle ist bevorzugt in ein Kunststoffmaterial, besonders bevorzugt EVA eingebettet. Dieses Material verbindet gleichzeitig die äußere Glasscheibe 10 und die innere Glasscheibe 12, so dass eine Verbundglasscheibe mit eingebetteten Solarzellen entsteht. An der Außenkante der Glasscheiben 10, 12 befindet sich ein Rahmen 60. Dieser ist hier in einer bevorzugten Ausführungsform dargestellt und umschließt entsprechend die Außenseite der Glasscheibe. Bevorzugt ist in den Rahmen 60 noch ein Einleger 52, beispielsweise aus Stahl eingebettet. Dieser verleiht dem Rahmen und somit dem Bauelement zusätzliche mechanische Stabilität. Zudem ermöglicht er eine einfache Befestigung beispielsweise durch Befestigungsschrauben 53 oder Bolzen mit der Karosserie eines Fahrzeugs oder dem Halterahmen beispielsweise einer Fassade. Bevorzugt ist wenigstens eine Dichtung zwischen dem Rahmen 60 und der Karosserie eines Fahrzeugs 60 oder dem Halterahmen beispielsweise einer Fassade angebracht. So kann in einem äußeren Bereich eine äußere Dichtung 62 und in einem inneren Bereich eine innere Dichtung 64 vorgesehen sein. Besonders bevorzugt befindet sich zwischen der äußeren Dichtung 62 und der inneren Dichtung 64 sowie zwischen dem Rahmen 60 und dem Fahrzeug bzw. Bauwerk 50 ein Hohlraum 68 zum Wassermanagement, mit dem beispielsweise noch durch die äußere Dichtung eingedrungenes Wasser abgeleitet werden kann.

In diesem Ausführungsbeispiel ist die Solarzelle 21 mit der Solarzelle 22 über den Zellverbinder 42 verbunden. Die Solarzelle 21 kann über den Zellverbinder 41 nach außen kontaktiert oder mit einer Solarzelle einer anderen Reihe durch einen Querverbinder 45 verbunden werden. Ein Querverbinder 45 kann auch zur externen Kontaktierung eingesetzt werden. Um eine besonders hohe mechanische Festigkeit zu erreichen, kann der Querverbinder 45 vollständig oder teilweise von dem Rahmen (60) fest umschlossen sein. Bevorzugt besteht hier ein Form- oder Kraftschluss. Somit können über den Querverbinder 45 durch den Zellverbinder Zugkräfte von den Solarzellen aufgenommen werden, was zu einer wesentlichen Verbesserung der Stabilität dient.

In der Figur 7 ist eine weitere Variante eines Bauelements dargestellt. Auch hier sind Solarzellen 21, 22 mittels einer Einbettung 15 zwischen einer äußeren Glasscheibe 10 und einer inneren Glasscheibe 12 eingebettet. Das Bauelement wird nun ähnlich wie eine Windschutzscheibe in die Karosserie bzw. den Rahmen eines Fahrzeugs durch ein Klebemittel 65 eingeklebt. Die Zellverbinder 41 einer am Rand liegenden Solarzelle 21 werden zwischen den beiden Glasscheiben hinaus und durch das für Klebemittel 65 hindurch geführt. Es gibt sich hierdurch eine sehr stabile Befestigung des Bauelements an dem Fahrzeug. Dadurch, dass die Zellverbinder durch das Klebemittel hindurch geführt werden ergibt sich zudem eine wesentliche Erhöhung der mechanischen Stabilität, da die Zellverbinder selbst hier nun auch im Falle einer extrem starken Belastung, wie diese beispielsweise bei einem Unfall auftreten kann, auf Zug belastet werden können und somit zur weiteren Stabilisierung des Bauelements beitragen. Um eine weitere Erhöhung der mechanischen Festigkeit zu erreichen kann auch wenigstens ein Querverbinder 45 in die Einbettung 15 und/oder das Klebemittel 65 mit eingebettet sein. Bevorzugt besteht hier ein Form- oder Kraftschluss. Bevorzugt ist noch eine äußere Dichtung 62 zur Abdichtung der äußeren Glasscheibe gegenüber dem Fahrzeug vorgesehen.

### Bezugszeichenliste

- 10: äußere Glasscheibe
- 12: innere Glasscheibe
- 13: innerer Träger
- 14: Bohrung
- 15: EVA Einbettung
- 16: Splitterschutzfolie
- 17: Folienträger
- 18: Bohrung
- 20, 21, 22: Solarzelle
- 30: Zellverbinder
- 31, 32, 33, 45: Querverbinder
- 41, 42: Zellverbinder
- 50: Karosserie / Rahmen
- 52: Stahleinleger
- 53: Verschraubung
- 60: PU Rahmen
- 62: äußere Dichtung
- 64: innere Dichtung
- 65: Verklebung
- 68: Hohlraum
- 80: verformter, strukturierter Bereich

## Patentansprüche

1. Bauelement für die Fassade eines Bauwerks oder für den Deckel eines Fahrzeugs, umfassend eine Glasscheibe (10) mit wenigstens einer Splitterschutzfolie (16) und wenigstens einer Solarzelle (20) zwischen der Glasscheibe (10) und der Splitterschutzfolie (16), wobei am Rand der Glasscheibe wenigstens ein fest mit der Folie verbundener Folienträger (17) angeordnet ist, und wobei die Glasscheibe (10) und der Folienträger (17) zur Verklebung mit einem Bauwerk oder einem Fahrzeug vorgesehen ist, und dass wenigstens ein Zellverbinder (41), welcher zur elektrischen Kontaktierung mit der wenigstens einen Solarzelle (20) verbunden ist, zumindest abschnittsweise an der Unterseite des Folienträgers (17) entlang geführt ist, so dass der wenigstens eine Zellverbinder (41) von einem Klebemittel (65) zur Verbindung mit dem Bauwerk oder dem Fahrzeug zumindest teilweise fest umschlossen ist und mit diesem Klebemittel (65) einen Kraftschluss und/oder Formschluss bildet.

2. Bauelement nach Anspruch 1,
**dadurch gekennzeichnet, dass**
wenigstens ein Folienträger an jeweils gegenüberliegenden Seiten der Glasscheibe (10) angeordnet ist.

3. Bauelement nach Anspruch 1,
**dadurch gekennzeichnet, dass**
wenigstens ein Folienträger umlaufend am Rand der Glasscheibe (10) angeordnet ist.

4. Bauelement nach einem der vorhergehenden Ansprüche,
**dadurch gekennzeichnet, dass**
der wenigstens eine Folienträger (17) ein mechanisch steifes Material wie einen Glasfaser- oder Kohlefaser-Verbundwerkstoff umfasst.

5. Bauelement nach einem der vorhergehenden Ansprüche,
**dadurch gekennzeichnet, dass**
wenigstens ein Zellverbinder (41) durch eine Bohrung (14) in dem wenigstens einen Folienträger (17) verläuft.

6. Bauelement für die Fassade eines Bauwerks oder für den Deckel eines Fahrzeugs, umfassend eine Glasscheibe (10) mit wenigstens einem inneren Träger (13) und wenigstens einer Solarzelle (20) zwischen der Glasscheibe (10) und dem inneren Träger (13), wobei die Glasscheibe (10) und der inneren Träger (13) zur Verklebung mit einem Bauwerk oder einem Fahrzeug vorgesehen ist, und wobei wenigstens ein Zellverbinder (41), welcher zur elektrischen Kontaktierung mit der wenigstens einen Solarzelle (20) verbunden ist, zumindest abschnittsweise an der Unterseite des inneren Trägers (13) entlang geführt ist, so dass der wenigstens eine Zellverbinder (41) von einem Klebemittel (65) zur Verbindung mit dem Bauwerk oder dem Fahrzeug zumindest teilweise fest umschlossen ist und mit diesem Klebemittel (65) einen Kraftschluss und/oder Formschluss bildet.

7. Bauelement nach einem der vorhergehenden Ansprüche,
**dadurch gekennzeichnet, dass**
der wenigstens eine inneren Träger (13) ein mechanisch steifes Material wie einen Glasfaser- oder Kohlefaser-Verbundwerkstoff umfasst.

8. Bauelement nach einem der vorhergehenden Ansprüche,
**dadurch gekennzeichnet, dass**
wenigstens ein Zellverbinder (41) durch eine Bohrung (18) in dem wenigstens einen inneren Träger (13) verläuft.

9. Bauelement nach einem der vorhergehenden Ansprüche,
**dadurch gekennzeichnet, dass**
wenigstens ein Querverbinder (31, 32, 33, 45) vorgesehen ist, welcher mit mindestens einem Zellverbinder (41) elektrisch und mechanisch verbunden ist und vollständig oder teilweise von dem Klebemittel (65) fest umschlossen ist.

10. Bauelement nach Anspruch 9,
**dadurch gekennzeichnet, dass**
der wenigstens eine Querverbinder (31, 32, 33) mit mehreren Zellverbindern verbunden ist.

11. Bauelement nach einem der vorhergehenden Ansprüche,
**dadurch gekennzeichnet, dass**
der wenigstens eine Zellverbinder und/oder der wenigstens eine Querverbinder einen verformten Bereich (80) und/oder einen strukturierten Bereich mit Vertiefungen und/oder Bohrungen zur Verbesserung des Formschlusses aufweist.

12. Bauwerk oder Fahrzeug umfassend wenigstens ein Bauelement nach einem der vorhergehenden Ansprüche.

13. Verfahren zur Herstellung eines Bauelements für die Fassade eines Bauwerks oder für den Deckel eines Fahrzeugs, umfassend die Schritte
a. Bereitstellen einer Glasscheibe (10),
b. Anordnen wenigstens einer ersten Schicht einer Einbettungsmaterials (15) auf der Glasscheibe,
c. Anordnen von wenigstens einer Solarzelle (21, 22) mit wenigstens einem Zellverbinder (41) auf der wenigstens einen ersten Schicht eines Einbettungsmaterials,
d. Anordnen wenigstens einer zweiten Schicht einer Einbettungsmaterials (15) auf der wenigstens einen Solarzelle (21, 22),
e. Anordnen einer Splitterschutzfolie (16) mit einem Folienträger (17) oder eines inneren Trägers (13) auf der wenigstens einen zweiten Schicht eines Einbettungsmaterials (15),
f. Herstellen eines Laminats durch Verpressen bzw. Laminieren der äußeren Glasscheibe (10) mit den daran angeordneten Materialien, derart, dass wenigstens ein Zellverbinder (41) aus dem Zwischenraum zwischen der äußeren Glasscheibe (10) und Folienträger (17) oder dem inneren Träger (13) herausragt oder durch wenigstens eine Bohrung im Folienträger (17) oder dem inneren Träger (13) hindurchgeht,
